# EUROPÄISCHE PATENTSCHRIFT

(11) **EP 1 739 835 B1**
(45) Veröffentlichungstag und Bekanntmachung des Hinweises auf die Patenterteilung: **31.10.2018**
(21) Anmeldenummer: 06009795.3
(22) Anmeldetag: 12.05.2006
(51) Int. Cl.: H03K 17/18

(54) **Schaltungsanordnung mit Fehlererkennung zur Ansteuerung von Leistungshalbleiterschaltern**
Circuit for controlling semiconductor power switches with error detection
Circuit pour la commande de commutateurs semi-conducteurs de puissance avec détection d'erreur

(30) Priorität: 23.05.2005 DE 102005023652
(43) Veröffentlichungstag der Anmeldung: 03.01.2007
(73) Patentinhaber: SEMIKRON Elektronik GmbH & Co. KG, 90431 Nürnberg (DE)
(72) Erfinder: Pawel, Sascha, 99867 Gotha (DE); Pawel, Ilja, 99867 Gotha (DE); Herzer, Reinhard, 98693 Ilmenau (DE)

(56) Entgegenhaltungen:
- EP-A2- 0 664 595
- DE-A1- 10 343 278
- DE-B3- 10 316 223
- US-A1- 2003 112 040

## Beschreibung

Die Erfindung betrifft eine vorzugsweise integrierte Schaltungsanordnung zur Ansteuerung von Leistungsschaltern angeordnet in Brückenschaltungstopologie sowie ein zugehöriges Verfahren. Derartige Brückenanordnungen von Leistungsschaltern sind als Halb-, H- (Zweiphasen-), oder als Dreiphasenbrückenschaltungen bekannt, wobei die einphasige Halbbrücke den Grundbaustein derartiger leistungselektronischer Schaltungen darstellt. In einer Halbbrückenschaltung sind zwei Leistungsschalter, ein erster, sog. TOP-Schalter und ein zweiter sog. BOT- Schalter in einer Reihenschaltung angeordnet. Eine derartige Halbbrücke weist in der Regel eine Verbindung zu einem Gleichstromzwischenkreis auf. Die Mittelanzapfung ist typischerweise mit einer Last verbunden.

Bei Ausgestaltung der Leistungsschalter als ein Leistungshalbleiterbauelement, oder als eine Mehrzahl gleichartiger in Reihe oder parallel geschalteter Leistungshalbleiterbauelemente, ist zur Ansteuerung der Leistungsschalter eine Ansteuerschaltung notwendig. Derartige Ansteuerschaltungen bestehen nach dem Stand der Technik aus mehreren Teilschaltungen bzw. Funktionsblöcken. Das von einer übergeordneten Steuerung kommende Ansteuersignal wird in einer ersten Teilschaltung, der Primärseite, aufbereitet und über weitere Komponenten den Treiberschaltungen, den Sekundärseiten, und schließlich dem Steuereingang des jeweiligen Leistungsschalters zugeführt. Bei Halbbrückenanordnungen mit höheren Zwischenkreisspannungen, beispielhaft größer 50V, wird die Primärseite zur Aufbereitung der Steuersignale potentialmäßig / galvanisch von der Sekundärseite getrennt, da sich die Leistungsschalter, zumindest der TOP- Schalter der Halbbrücke im Betrieb auf keinem konstanten Potential befinden und somit eine spannungsmäßige Isolation unumgänglich ist. Diese Trennung erfolgt nach dem Stand der Technik beispielhaft mittels Übertragern, Optokopplern bzw. Lichtwellenleitern. Diese galvanische Trennung wird zumindest für den TOP-Schalter, bei höheren Leistungen aber auch für den BOT- Schalter auf Grund eines möglichen Verrisses des Masse- Bezugspotentials beim Schalten ausgeführt.

Bekannt sind auch integrierte Schaltungsanordnungen für Leistungsschalter der Spannungsklassen bis 600V oder 1200V, die auf eine externe galvanische Trennung verzichten. Bei diesen monolithisch integrierte Schaltungen werden nach dem Stand der Technik so genannte Levelshifter, zumindest für den TOP- Schalter, eingesetzt, Diese elektronischen Bauelemente und Isolationstechniken überwinden somit die die Potentialdifferenz von der Primärseite zur Sekundärseite.

In dieser beschriebenen Ausgestaltung der integrierten Schaltungsanordnung zur Ansteuerung von Leistungsschaltern ist zumindest in der einfachsten Konfiguration für die Sekundärseite des TOP- Schalters keine Möglichkeit zur Rückmeldung eines Fehlers an die Primärseite gegeben. Die US 2003/0112040 A1 offenbart eine aufwendige Möglichkeit der der Rückmeldung, indem für den Rückmeldekanal ein eigener Levelshifter vorgesehen ist.

Der Erfindung liegt die Aufgabe zugrunde eine, vorzugsweise monolithisch integrierte, Schaltungsanordnung für Leistungshalbleiterschalter in Brückenanordnung sowie ein zugehöriges Verfahren vorzustellen, welches eine primärseitige Erkennung des Schaltzustandes mindestens eines Leistungshalbleiterschalters der Sekundärseite mittels einfacher und integrierbarer Mittel gestattet.

Die Aufgabe wird erfindungsgemäß gelöst, durch die Maßnahmen der Merkmale der Ansprüche 1 und 5. Bevorzugte Ausführungsformen sind in den Unteransprüchen beschrieben.

Der erfinderische Gedanke geht aus von einer bekannten Schaltungsanordnung zur Ansteuerung von Leistungshalbleiterschaltern in Brückentopologie bestehend aus einem primärseitigen Teil (Primärseite) und pro Leistungshalbleiterbauschalter einem sekundärseitigen Teil (Sekundärseite). Die Brückenschaltung besteht aus einem ersten, dem TOP und einem zweiten den BOT- Schalter. Diese sind nach dem Stand der Technik mit einem Gleichstromzwischenkreis verbunden. Der Mittenabgriff zwischen dem TOP und dem BOT- Schalter bildet den Wechselstromausgang der Brückenschaltung. Die Schaltungsanordnung zur Ansteuerung weist auf ihrer Primärseite mindestens eine Signalverarbeitung sowie mindestens einen Levelshifter zur potentialfreien Ansteuerung der mindestens einen Sekundärseite auf. Diese Sekundärseite weist ihrerseits mindestens eine Signalverarbeitung sowie mindestens eine Treiberstufe für den jeweiligen Schalter auf.

Die Erfindung stellt eine monolitisch integrierte Schaltungsanordnung nach Anspruch 1 vor.

Das zugehörige Verfahren nach Anspruch 5 dient der primärseitigen Erkennung des Schaltzustandes eines sekundärseitig angesteuerten Leistungshalbleiterschalters. Hierzu wird der Stromfluss durch den Levelshifter auf der Primärseite ausgewertet. Hierbei entspricht ein erster unterer Schwellwert dieses auf der Primärseite detektierten Stroms durch den Levelshifter einem nicht eingeschalteten Schalter der Brückenschaltung, wohingegen ein zweiter oberer Schwellwert dieses auf der Primärseite detektierten Stroms durch den Levelshifter einem eingeschalteten Schalter der Brückenschaltung entspricht.

Der erfinderische Gedanke wird anhand der Ausführungsbeispiele der Fig. 1 bis 6 näher erläutert.
Fig. 1 zeigt eine Schaltungsanordnung nach dem Stand der Technik.
Fig. 2 zeigt einen Levelshifter nach dem Stand der Technik.
Fig. 3 zeigt eine erfindungsgemäß weitergebildete Schaltungsanordnung.
Fig. 4 zeigt den Zusammenhang zwischen dem Stromfluss durch den Levelshifter und der Schwellwertbildung.
Fig. 5 zeigt eine erste weitergebildete Ausgestaltung eines Levelshifters zur Anordnung in einer erfindungsgemäßen Schaltungsanordnung.
Fig. 6 zeigt eine zweite weitergebildete Ausgestaltung eines Levelshifters zur Anordnung in einer erfindungsgemäßen Schaltungsanordnung.

Bei der Ansteuerung von Leistungshalbleiterbauelementen (50, 52), wie beispielhaft IGBTs (insulated gate bipolar transistor) mit antiparallel geschalteter Freilaufdiode, in einer Schaltungsanordnung in Brückentopologie, ist aufgrund der Spannungsdifferenz zwischen der übergeordneten Steuerung (10) beispielhaft in Form eines Mikrokontrollers (10) und der Primärseite (20) der Schaltungsanordnung einerseits und der Sekundärseite (30, 32) der Schaltungsanordnung und dem Leistungshalbleiterbauelement (50, 52) andererseits eine Potentialtrennung notwendig. Dem Stand der Technik entsprechend, sind verschiedenen Möglichkeiten der Potentialtrennung bekannt, beispielhaft Transformatoren, Optokoppler, Lichtwellenleiter oder elektronische Bauelemente mit entsprechender Spannungsfestigkeit.

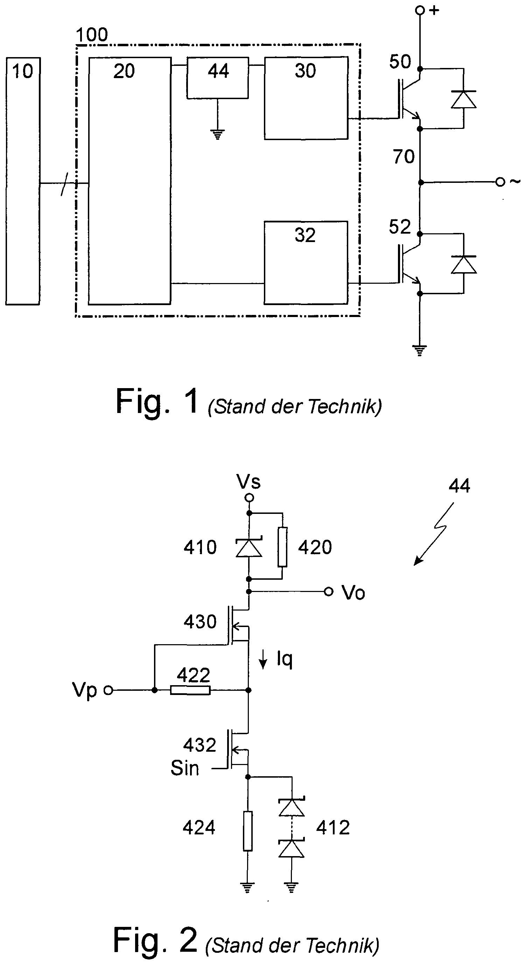

Bei der monolithischen Integration von Primärseite (20) und Sekundärseite (30) einer Schaltungsanordnung (100) zur Ansteuerung von Leistungshalbleiterschaltern (50, 52) gemäß Fig. 1 werden zur Übertragung von Steuersignalen von der Primärseite (20) zur Sekundärseite häufig Levelshifter (44) eingesetzt.

Mit den genannten Bauelementen zur Potentialtrennung können Ein- und Ausschaltsignale von der Primärseite (20, Niederspannungsseite) auf die Sekundärseite (30, Hochspannungsseite) übertragen werden. Wesentlich für den störungsfreien Betrieb eines leistungselektronischen Systems ist allerdings auf der Primärseite (20) die Kenntnis von Betriebszuständen der Sekundärseite (30), beispielhaft über die konkreten Schaltzustände des TOP- und des BOT- Schalters.

Fig. 2 zeigt eine bekannte Topologie eines monolithisch integrierten Levelshifter, hier mit einem nMOS- Hochspannungstransistor (430) mit einer Sperrfähigkeit entsprechend der maximalen Potentialdifferenz zwischen Primär- (20) und Sekundärseite (30). Die Ansteuerung der Sekundärseite erfolgt von der Primärseite aus. Sobald die Primärseite (20) den Hochspannungstransistor (430) einschaltet fließt ein Querstrom (Iq) zwischen der Versorgungsspannung (Vs) der Sekundärseite und dem Masse-Bezugspotential der Primärseite (20). Dieser Stromfluss (Iq) wird auf der Sekundärseite detektiert und in ein weiterzuverarbeitendes Signal gewandelt.

Der Levelshifter (44) wird durch das Eingangssignal (Sin) gesteuert. Vorzugsweise wird dieses Signal hierzu vorverstärkt und an den Steuereingang eines Niederspannungstransistors (432) angelegt. Solange dieser Niederspannungstransistor (432) geöffnet ist, liegt an "Source" des Hochspannungstransistors (430) das Potential der Versorgungsspannung (Vp) der Primärseite an. Da das "Gate" des Hochspannungstransistors (430) ebenfalls an der Versorgungsspannung (Vp) der Primärseite (20) liegt, fällt die gesamte Offsetspannung zwischen Primärseite und Sekundärseite über dem Hochspannungstransistor (430) ab. Wird der Niederspannungstransistor (432) eingeschaltet sinkt das Potential an Source des Hochspannungstransistors (430) und ein Querstrom (Iq) beginnt zu fließen. Allerdings wird dieser Strom durch den Gegenkopplungswiderstand (424) begrenzt. Der Querstrom (Iq) übermittelt somit das Schaltsignal der Primärseite auf die Sekundärseite, indem dort der Spannungsabfall über dem Widerstand (420) ausgewertet wird. Im stationären Zustand, bei einem Eingangssignal (Sin) von "low", verbraucht diese Schaltung mit Ausnahme des zu vernachlässigenden Leckstroms des Hochspannungstransistors (430) keine Energie. Der Signalhub auf der Sekundärseite ist durch die Zenerdiode (410) begrenzt. Die primärseitige Serienschaltung von Zenerdioden (412) schützt zusammen mit dem Widerstand (424) den Niederspannungstransistor (432) vor transienter Überspannungsbelastung.

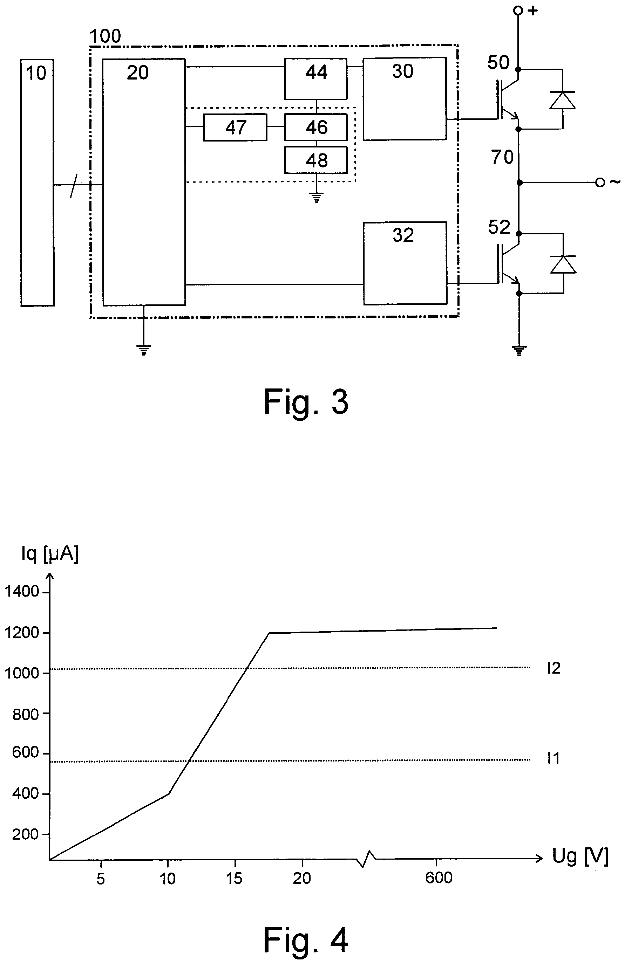

Infolge des Clampings auf der Sekundärseite und der Strombegrenzung über Emittergegenkopplung variiert der Querstrom (Iq) während der Einschaltpulse am Hochspannungstransistor (430) mit der Offsetspannung. Dabei spiegelt sich in den Drainstromwerten über der Offsetspannung das Sättigungsverhalten des Hochspannungstransistors wider (vgl. Fig. 4).

Die Gesamtspannung (vgl. (Ug) in Fig.4) ergibt sich aus dem Potentialunterschied zwischen dem primärseitigen Masse- Bezugspotentials und der sekundärseitigen Spannungsversorgung (Vs). Dies entspricht somit der Summe aus der Offsetspannung zwischen Primär- und Sekundärseite und der sekundärseitigen Betriebsspannung.
Fig. 3 zeigt eine erfindungsgemäß weitergebildete monolithisch integrierte Schaltungsanordnung (100), die allerdings in gleicher Weise auch als hybride Schaltungsanordnung realisiert werden kann. Bei der erfindungsgemäßen Weiterbildung wird der Levelshifter (44) auf der Primärseite (20) ergänzt um eine Strom- (46) und eine Spannungserfassung (47), sowie um eine Strombegrenzung (48). Abhängig von der Gesamtspannung (Ug) stellt sich der Querstrom (Iq) ein. Dieser wird über die Stromerfassung (46) ermittelt und mittels der Spannungserfassung (47) in ein verwertbares Signal umgesetzt. Der Strombegrenzer (48) dient der Begrenzung der Belastung des Hochspannungstransistors sowie der Begrenzung des Stromverbrauchs des Levelshifters (44).
Die Leistungshalbleiterschalter (50, 52) der Brückenanordnung werden im Schaltbetrieb verwendet, d.h. sie werden wechselseitig ein- und ausgeschaltet. Die Mittelanzapfung (Ausgang) der Brücke weist folglich nur zwei stationäre Zustände auf. Im Falle eines eingeschalteten TOP- Schalters (50) bei ausgeschaltetem BOT- Schalter (52), liegt die Mittelanzapfung nahe der Zwischenkreisspannung, im Falle eines ausgeschaltetetn TOP-Schalter (50) bei eingeschaltetem BOT- Schalter (52) nahe dem Masse- Bezugspotential. Zur Detektion des Schaltzustandes des TOP- Schalters (50) muss daher lediglich die Höhe des Querstroms (Iq) des Levelshifters (44) auf der Primärseite (20) erfasst werden, der sich in Abhängigkeit von der Höhe der Gesamtspannung (Ug) einstellt.

Wird ein Einschaltimpuls von der Primärseite (20) zur Sekundärseite (30) über den Levelshifter (44) übermittelt, hängt hierbei der Querstrom (Iq) von der Gesamtspannung (Ug) ab. Ein eingeschalteter TOP- Schalter (50) geht mit einer Erhöhung der Gesamtspannung einher. Auf Grund der beschriebenen Charakteristik des Levelshifters (44) korrespondiert diese Erhöhung der Gesamtspannung mit einer Erhöhung des Querstroms Iq. Fig. 4 zeigt diesen Zusammenhang schematisch aus Sicht der Detektionsschaltung auf der Primärseite. Hier wird eine Erhöhung des Querstroms (Iq) über einen zweiten Schwellwert (I2) bestimmt und als die Folge des Einschaltens des TOP-Schalters ausgewertet. Demgegenüber wird das nicht Erreichen (Unterschreiten) eines ersten Schwellwerts (I1), als nicht Einschalten des TOP- Schalters gewertet. Zwischen erstem Schwellwert und zweiten Schwellwert befindet sich eine schaltungsgerecht festzulegende Stromdifferenz zur korrekten Erkennung der Schaltzustände. Somit ist es durch die primärseitige Messung des Querstroms (Iq) möglich sicher festzustellen, ob der sekundärseitige Schalter in Folge des übertragenen Einschaltsignals eingeschaltet wurde oder nicht.

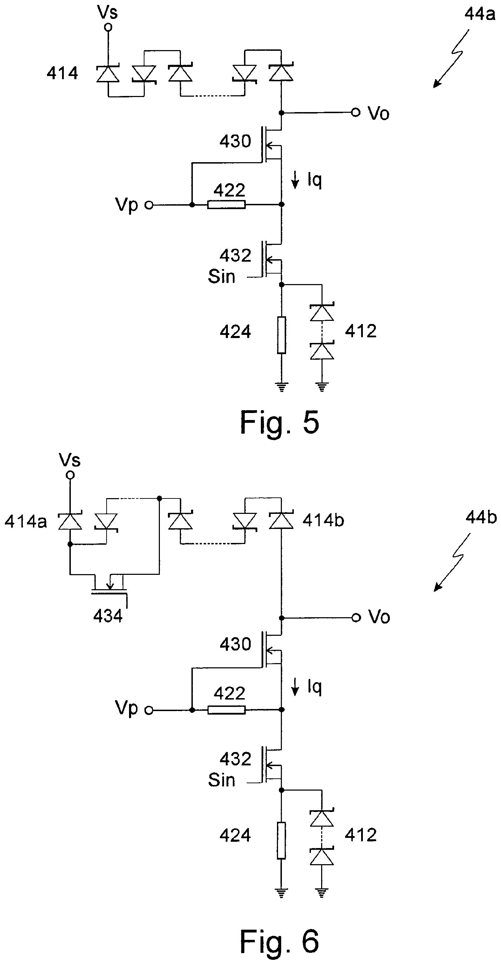

Fig. 5 zeigt eine erste weitergebildete Ausgestaltung eines Levelshifters (44a) zur Anordnung in einer erfindungsgemäßen Schaltungsanordnung. Zur Vereinfachung der Detektion des Querstroms (Iq) können die Schwellwerte verschoben werden. Hierzu wird die Sekundärseite des Levelshifters (44a) durch eine Potentialverschiebung modifiziert. Die Reihenschaltung von Zenerdioden (414) ersetzt hierbei die einzelne Zenerdiode (410) und den parallel geschalteten Widerstand (420) aus Fig. 2. Diese Anordnung verschiebt im Betrieb den Sättigungswert des Querstroms (Iq) bezüglich der Gesamtspannung (Ug) und führt zu einer symmetrischen Übertragungscharakteristik. Dies bedeutet, dass die Steilheit der Strom- Spannungsänderung im Bereich diesseits der ersten Schwelle (I1, vgl. Fig. 4) und jenseits der zweiten Schwelle (I2) annährend gleich ausgebildet ist. Vorteilhaft an dieser Ausgestaltung des Levelshifters (44a) ist, dass somit auch während eines Zeitraums in dem der zugeordnete Schalter bereits vermeintlich eingeschaltet ist, durch einen weiteren Einschaltimpuls eine Funktionskontrolle ausgeführt werden kann. Auch in diesem Fall ergibt eine Auswertung des Querstroms (Iq) eine Rückmeldung über den Schaltzustand des TOP-Schalters. Indirekt können mit dieser Rückmeldung Fehlerzustände der Sekundärseite, z.B. Abschalten aufgrund von Unterspannungsfehler, auf die Primärseite und damit an die übergeordnete Steuerung übermittelt werden.

Fig. 6 zeigt eine zweite weitergebildete Ausgestaltung eines Levelshifters (44b) zur Anordnung in einer erfindungsgemäßen Schaltungsanordnung, die auf dem Levelshifter (44a) gemäß Fig. 5 basiert. Nachteilig an dieser Ausgestaltung gemäß Fig. 5 ist, dass hier eine Fehlerübertragung ausschließlich von der Primärseite eingeleitet werden kann, die Sekundärseite aber nicht aktiv einen Fehler an die Primärseite übermitteln kann. Um dies zu ermöglichen wird die Reihenschaltung (414) der Zenerdioden auf der Sekundärseite derart weitergebildet, dass zu einer Mehrzahl dieser Zenerdioden (414a) ein Mittelspannungstransistor (434) parallel geschaltet wird, der eine höher Spannungsfestigkeit aufweisen muss als die Summe der Spannungen der Zenerdioden (414a). Die übrigen Zenerdioden (414b) bleiben von dieser Modifikation unberührt. Vorteilhaft ist hierbei, speziell bei der monolithischen Integration, dass derartige Mittelspannungstransistoren (434) einen geringeren Flächenbedarf aufweisen als Hochspannungstransistoren (432) und somit technologisch einfacher, Platz sparender und kostengünstiger in die Schaltungsanordnung zu integrieren sind als ein eigener Rückmeldepfad über Hochspannungstransistoren von der Sekundärseite zu Primärseite.

Im Falle eines von der Sekundärseite angesteuerten und im Normalbetrieb ausgeschaltetem Mittelspannungstransistors (434) ist das Verhalten des Levelshifters (44b) identisch demjenigen unter Fig. 5, d.h. es fließt nur in der Ansteuerphase des Levelshifter ein signifikanter Querstrom (Iq). In einem beliebigen Fehlerfall kann die Sekundärseite diesen Mittelspannungstransistor aktiv einschalten und somit einen Querstromfluss initiieren. Dieser wird auf der Primärseite erkannt und als Fehlersignal von der Sekundärseite zur Primärseite identifiziert.

## Patentansprüche

1. Schaltungsanordnung (100), monolithisch integriert, zur Ansteuerung von Leistungshalbleiterschaltern (50, 52) in Brückentopologie bestehend aus einem primärseitigen Teil (Primärseite, 20) und jeweils einem sekundärseitigen Teil (Sekundärseite, 30) für den TOP- (50) und den BOT- Schalter (52) der Brückenschaltung, wobei die Primärseite (20) mindestens eine Signalverarbeitung und mindestens einen zugeordneten Levelshifter (44), der zur Übertragung von Ansteuersignalen von der Primärseite (20) zur Sekundärseite (30) dient, zur potentialfreien Ansteuerung mindestens einer Sekundärseite (30) aufweist und diese Sekundärseite (30) mindestens eine Signalverarbeitung sowie mindestens eine Treiberstufe für den jeweiligen Schalter (50) aufweist, wobei zur Erkennung des Schaltzustandes mindestens eines Leistungshalbleiterschalters (50), auf der Primärseite (20) mindestens ein Schaltungsteil (46, 47, 48) zur Detektion und Auswertung eines Stromflusses (Iq) durch den zugeordneten Levelshifter (44) angeordnet ist.

2. Schaltungsanordnung (100) nach Anspruch 1,
wobei der Levelshifter (44) eine sekundärseitige Spannungsversorgung (Vs), mindestens eine Zenerdiode (410), einen sekundärseitigen Ausgang (Vo), einen Hochspannungstransistor (430), eine primärseitige Spannungsversorgung (Vp) und einen Niederspannungstransistor (432) aufweist.

3. Schaltungsanordnung (100) nach Anspruch 2,
wobei der Levelshifter (44) auf der Sekundärseite nach der dortigen Spannungsversorgung eine Reihenschaltung von Zenerdioden (414) aufweist.

4. Schaltungsanordnung (100) nach Anspruch 3,
wobei die Reihenschaltung von Zenerdioden (414 a/b) derart modifiziert wird, dass parallel zu einer Mehrzahl dieser Zenerdioden (414a) ein Mittelspannungstransistor (434) angeordnet ist.

5. Verfahren zur Erkennung des Schaltzustandes eines Leistungshalbleiterschalters (50) in einer Schaltungsanordnung (100) nach Anspruch 1,
wobei der Stromfluss (Iq) durch den Levelshifter (44) auf der Primärseite (20) mittels dort angeordneter Schaltungsteile (46,47,48) ausgewertet wird, hierbei ein erster unterer Schwellwert (I1) dieses auf der Primärseite (20) detektierten Stroms (Iq) durch den Levelshifter (44) einem nicht eingeschalteten Schalter (50) der Brückenschaltung entspricht und ein zweiter oberer Schwellwert (I2) dieses auf der Primärseite (20) detektierten Stroms (Iq) durch den Levelshifter (44) einem eingeschalteten Schalter (50) der Brückeschaltung entspricht.

6. Verfahren nach Anspruch 5,
wobei der Stromfluss (Iq) durch den Levelshifter (44) mittels einer Strom- (46) und Spannungserfassung (47) detektiert wird.

7. Verfahren nach Anspruch 5,
wobei eine Strombegrenzung (48) auf der Primärseite (20) eine Überlastung des Levelshifters (44) verhindert.

## Claims

1. Circuit arrangement (100), monolithically integrated, for actuating power semiconductor switches (50, 52) in bridge topology consisting of a primary-side part (primary side 20) and in each case one secondary-side part (secondary side 30) for the TOP (50) and BOT (52) switches of the bridge circuit, wherein the primary side (20) has at least one signal processing section and at least one associated level shifter (44), used for transmitting actuation signals from the primary side (20) to the secondary side (30), for zero-potential actuation of at least one secondary side (30), and this secondary side (30) has at least one signal processing section and also at least one driver stage for the respective switch (50), wherein for the purpose of detecting the switching state of at least one power semiconductor switch (50) there is at least one circuit portion (46, 47, 48) arranged on the primary side (20) for detecting and evaluating a flow of current (Iq) through the associated level shifter (44).

2. Circuit arrangement (100) according to Claim 1,
wherein the level shifter (44) has a secondary-side power supply (Vs), at least one zener diode (410), a secondary-side output (Vo), a high-voltage transistor (430), a primary-side power supply (Vp) and a low-voltage transistor (432).

3. Circuit arrangement (100) according to Claim 2,
wherein the level shifter (44) has a series connection of zener diodes (414) on the secondary side downstream of the power supply there.

4. Circuit arrangement (100) according to Claim 3,
wherein the series connection of zener diodes (414 a/b) is modified such that a medium-voltage transistor (434) is arranged in parallel with a plurality of these zener diodes (414a).

5. Method for detecting the switching state of a power semiconductor switch (50) in a circuit arrangement (100) according to Claim 1,
wherein the flow of current (Iq) through the level shifter (44) on the primary side (20) is evaluated by means of circuit portions (46, 47, 48) arranged there, and in this case a first lower threshold value (I1) for this current (Iq) through the level shifter (44) that is detected on the primary side (20) is consistent with an unengaged switch (50) of the bridge circuit and a second upper threshold value (12) for this current (Iq) through the level shifter (44) that is detected on the primary side (20) is consistent with an engaged switch (50) of the bridge circuit.

6. Method according to Claim 5,
wherein the flow of current (Iq) through the level shifter (44) is detected by means of a current (46) and voltage (47) sensing section.

7. Method according to Claim 5,
wherein a current limiting section (48) on the primary side (20) prevents overload of the level shifter (44).

## Revendications

1. Agencement de circuit (100), intégré monolithiquement, pour la commande de commutateurs à semiconducteurs de puissance (50, 52) en topologie en pont, constitué d'une partie côté primaire (côté primaire, 20) et à chaque fois d'une partie côté secondaire (côté secondaire, 30) pour les commutateurs TOP (50) et BOT (52) du circuit en pont, le côté primaire (20) présentant au moins un traitement de signal et au moins un décaleur de niveau associé (44), qui sert à transmettre des signaux de commande du côté primaire (20) au côté secondaire (30), pour la commande au potentiel zéro d'au moins un côté secondaire (30) et ce côté secondaire (30) présentant au moins un traitement de signal ainsi qu'au moins un étage d'attaque pour le commutateur respectif (50), au moins une partie de circuit (46, 47, 48) pour la détection et l'analyse d'un flux de courant (Iq) à travers le décaleur de niveau associé (44) étant disposée sur le côté primaire (20) pour la détection de l'état de commutation d'au moins un commutateur à semiconducteurs de puissance (50).

2. Agencement de circuit (100) selon la revendication 1,
dans lequel le décaleur de niveau (44) présente une alimentation en tension du côté secondaire (Vs), au moins une diode Zener (410), une sortie du côté secondaire (Vo), un transistor haute tension (430), une alimentation en tension du côté primaire (Vp) et un transistor basse tension (432) .

3. Agencement de circuit (100) selon la revendication 2,
dans lequel le décaleur de niveau (44) présente du côté secondaire en aval de l'alimentation en tension à cet endroit, un montage en série de diodes Zener (414).

4. Agencement de circuit (100) selon la revendication 3,
dans lequel le montage en série de diodes Zener (414a/b) est modifié de telle sorte qu'un transistor à moyenne tension (434) soit disposé parallèlement à une pluralité de ces diodes Zener (414a).

5. Procédé pour détecter l'état de commutation d'un commutateur à semiconducteurs de puissance (50) dans un agencement de circuit (100) selon la revendication 1,
dans lequel le flux de courant (Iq) à travers le décaleur de niveau (44) du côté primaire (20) est analysé au moyen de parties de circuit (46, 47, 48) disposées à cet endroit, dans ce cas une première valeur seuil inférieure (I1) de ce courant (Iq) détecté du côté primaire (20) à travers le décaleur de niveau (44) correspond à un commutateur non enclenché (50) du circuit en pont et une deuxième valeur seuil supérieure (I2) de ce courant (Iq) détecté du côté primaire (20) à travers le décaleur de niveau (44) correspond à un commutateur enclenché (50) du circuit en pont.

6. Procédé selon la revendication 5,
dans lequel le flux de courant (Iq) à travers le décaleur de niveau (44) est détecté au moyen d'une détection de courant (46) et d'une détection de tension (47).

7. Procédé selon la revendication 5,
dans lequel une limitation du courant (48) du côté primaire (20) empêche une surcharge du décaleur de niveau (44).
